# FASCICULE DE BREVET EUROPEEN

(11) **EP 1 759 458 B1**
(45) Date de publication et mention de la délivrance du brevet: **12.11.2008**
(21) Numéro de dépôt: 05754115.3
(22) Date de dépôt: 21.06.2005
(51) Int. Cl.: H03J 1/00, H04N 5/50

(54) **PROCEDE DE VALIDATION D'UN NOMBRE DANS UN APPAREIL ELECTRONIQUE ET APPAREIL ELECTRONIQUE ASSOCIE**
VERFAHREN ZUR VALIDIERUNG EINER ZAHL IN EINER ELEKTRONISCHEN VORRICHTUNG UND ENTSPRECHENDE ELEKTRONISCHE VORRICHTUNG
METHOD FOR VALIDATING A NUMBER IN AN ELECTRONIC DEVICE AND ASSOCIATED ELECTRONIC DEVICE

(30) Priorité: 21.06.2004 FR 0406711
(43) Date de publication de la demande: 07.03.2007
(73) Titulaire: Thomson Licensing, 92100 Boulogne-Billancourt (FR)
(72) Inventeur: QUERRE, Goulven, F-35530 Noyal sur Vilaine (FR)
(74) Mandataire: Le Dantec, Claude
(86) Numéro de dépôt international: PCT/EP2005/052867
(87) Numéro de publication internationale: WO 2005/125009

(56) Documents cités:
- EP-A- 0 352 446
- WO-A-00/79788
- DE-A1- 3 404 976
- US-A- 5 020 139
- US-A- 5 483 685

## Description

La présente invention est relative à un procédé de validation d'une valeur numérique dans un appareil électronique. L'invention est relative également à un appareil électronique pour la mise en oeuvre du procédé.

Les commandes, et plus particulièrement les télécommandes, pour récepteur de télévision, décodeur, magnétoscope, lecteur ou enregistreur de disques, ou autres appareils électroniques comportent, en général, un pavé numérique possédant au moins 10 touches numérotées de « 0 » à « 9 ». Dans le cas des télécommandes, celles-ci permettent d'émettre des signaux codés transmis, le plus souvent par porteuse infrarouge, au récepteur à commander. Dans ce qui suit, pour simplifier l'exposé, on se référera seulement à un récepteur de télévision commandé par un dispositif de télécommande. Toutefois, l'invention s'applique de façon plus générale à tout type d'appareils susceptibles de recevoir une valeur numérique par un dispositif de commande, tel qu'un décodeur, un magnétoscope, un lecteur et/ou enregistreur de disques, etc.

Un exemple d'utilisation d'un pavé numérique est celui de la sélection d'un canal audiovisuel identifié par un numéro à au moins deux chiffres (plus communément appelé « digit »). Cette opération est souvent laborieuse car pendant ce temps, l'écran est souvent noir, ne sachant sur quel canal le récepteur doit se caler. L'opération consiste à introduire successivement les chiffres les plus significatifs (centaine, dizaine) d'abord et terminer par celui des unités.

Pour informer le récepteur des signaux de la télécommande que l'utilisateur a terminé d'introduire les chiffres composant le numéro, et pour que le programme puisse prendre en compte cet ensemble, une première façon de faire consiste à appuyer sur une autre touche, appelée généralement « Entrée » (ou « Enter » en langue anglo-saxonne). De cette manière, l'utilisateur termine les chiffres introduits. Mais ce premier signal de fin d'acquisition a pour inconvénient d'obliger l'utilisateur à appuyer sur une touche supplémentaire.

Un second signal de fin d'acquisition consiste à lancer une temporisation consécutivement à l'appui d'une touche, c'est-à-dire aussitôt après la réception par l'appareil du signal contenant le code de la touche enfoncée. Si la temporisation atteint une valeur déterminée, on considère que l'utilisateur a terminé d'introduire le numéro et donc l'ensemble des chiffres préalablement introduit constitue le numéro. La durée maximale de la temporisation est par exemple de deux secondes. Mais cette méthode a pour inconvénient d'allonger le temps d'introduction d'un numéro, par exemple un canal audiovisuel, et de ce fait pendant ce temps l'écran ne change pas et l'utilisateur peut se demander si les touches enfoncées ont bien été prises en compte.

La demande de brevet européen EP 352 446 décrit un dispositif de sélection de programmes dans des appareils dotés d'une télécommande. Le programme dont le caractère correspond à la première touche enfoncée est immédiatement sélectionné, puis une temporisation est lancée au cours de laquelle l'appareil prend en compte les éventuels caractères suivants afin de les concaténer pour obtenir l'identifiant complet du programme. Mais si l'identifiant du programme est codé sur plus d'un caractère, cette méthode sélectionne dans un premier temps un programme qui n'est pas désiré par l'utilisateur.

Le but de la présente invention est de corriger les inconvénients de l'art antérieur en simplifiant les opérations de l'utilisateur pour introduire un numéro comportant plusieurs chiffres et en augmentant la rapidité de la validation du numéro introduit.

La présente invention a pour objet un procédé de validation d'un nombre comportant une pluralité de chiffres, le nombre ayant une valeur maximale ; comportant une pluralité d'étapes d'introduction d'un chiffre ; caractérisé en ce qu'il comporte :
une première étape de validation (3.11) de l'ensemble des chiffres introduits lorsque :
   - le nombre de chiffres introduits est égal à celui de la valeur maximale (MAX) moins une unité, et
   - le chiffre de poids le plus significatif (MSB) introduit est plus grand que le chiffre de poids le plus significatif de la valeur maximale (MAX).

Ainsi, le procédé valide les chiffres introduits sans attendre une temporisation. De plus, le procédé n'a pas besoin de valider les chiffres introduits par l'introduction d'une touche spécifique.

Selon un premier perfectionnement, le nombre introduit est aussi validé lorsque le nombre introduit est inférieur ou égal à la valeur maximale (MAX), notamment dans le cas ou le nombre de chiffres introduits est égal à celui du nombre de chiffres de la valeur maximale. Ainsi, le module de validation contrôle en toute circonstance que le nombre validé est bien inférieur ou égal à la valeur maximale. Un autre perfectionnement consiste en ce que l'utilisateur puisse valider rapidement les chiffres introduits à l'aide d'une touche de commande. Un autre perfectionnement consiste en l'émission d'un signal sonore ou visuel lors de la validation du nombre.

Selon un autre perfectionnement, si le nombre de chiffres introduit est égal à celui de la valeur maximale (MAX) moins une unité, et si le chiffre de poids le plus significatif (MSB) introduit est égal au chiffre de poids le plus significatif de la valeur maximale (MAX), alors l'ensemble du nombre introduit est validé si le second chiffre introduit est plus grand que le second chiffre de poids le plus significatif de la valeur maximale (MAX).

L'invention a également pour objet un appareil électronique comprenant des moyens de réception d'une pluralité de signaux associés respectivement à un chiffre pour la constitution d'un nombre, et des moyens de mémorisation d'une valeur maximale ; caractérisé en ce qu'il comporte un premier moyen de validation de l'ensemble des chiffres introduits activé lorsque les deux événements suivants interviennent : le nombre de chiffres introduits est égal à celui de la valeur maximale moins une unité, et le chiffre de poids le plus significatif introduit est plus grand que le chiffre de poids le plus significatif de la valeur maximale.

Selon un perfectionnement, l'appareil comporte un moyen de comparaison entre le nombre introduit et la valeur maximale qui est activé lorsque l'étape de test n'est pas exécutée. Ce moyen de comparaison valide le nombre introduit à condition que celui-ci soit inférieur ou égal à la valeur maximale. Selon un autre perfectionnement, la télécommande dispose d'une touche permettant de terminer l'acquisition des chiffres introduits et ainsi d'écourter la l'acquisition du nombre. Selon un mode de réalisation particulier, l'appareil est une télécommande recevant un signal représentant la valeur maximale et émettant à destination d'au moins un appareil un signal contenant le nombre ainsi validé. Selon un perfectionnement de ce mode de réalisation, la télécommande comporte un écran tactile affichant un pavé numérique.

Selon un perfectionnement, l'appareil comporte un troisième moyen de validation du nombre introduit activé lorsque les trois événements interviennent ensemble: le nombre de chiffres introduits est égal à celui de la valeur maximale moins une unité, le chiffre de poids le plus significatif introduit est égal au chiffre de poids le plus significatif de la valeur maximale, et le second chiffre introduit est plus grand que le second chiffre de poids le plus significatif de la valeur maximale une comparaison des second chiffres se poursuivent à un chiffre de rang inférieur tant que les chiffres de rang supérieurs sont égaux.

D'autres caractéristiques et avantages de l'invention apparaîtront maintenant avec plus de détails dans le cadre de la description qui suit d'exemples de réalisation donnés à titre illustratif en se référant aux figures annexées qui représentent :
- la figure 1 est un diagramme bloc d'un récepteur audiovisuel pour la mise en oeuvre de l'invention,
- la figure 2 représente un boîtier d'une télécommande selon un exemple de réalisation de l'invention,
- la figure 3 est un organigramme représentant les principales étapes pour la mise en oeuvre d'un exemple de réalisation de l'invention,

Pour simplifier la description, les mêmes références seront utilisées pour désigner les éléments remplissant des fonctions identiques.

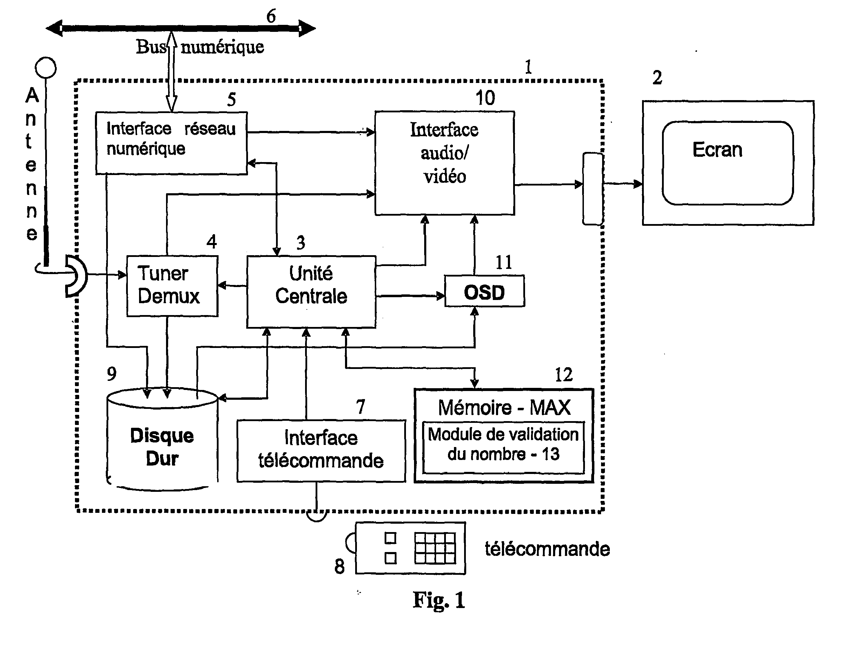

On décrira tout d'abord à l'aide de la figure 1, le fonctionnement d'un récepteur audiovisuel 1 muni d'un dispositif d'affichage 2. Le récepteur comprend une unité centrale 3 reliée à une mémoire 12 de programme (ROM) et de travail (RAM), et une interface 5 pour la communication avec un bus numérique local à haut débit 6 permettant de transmettre des données audio/vidéo en temps réel. Ce réseau est par exemple un réseau IEEE 1394. Ce bus numérique permet également d'envoyer des données à un serveur. Le récepteur peut également recevoir des données audio/vidéo d'un réseau de diffusion à travers une antenne de réception associée à un démodulateur 4. Le récepteur comprend en outre un récepteur de signaux infrarouge 7 pour recevoir les signaux d'une télécommande 8, un moyen de mémorisation 9 pour le stockage de contenus audiovisuels, et une logique de décodage audio/vidéo 10 pour la génération des signaux audiovisuels envoyés à l'écran de télévision 2. La mémoire 12 comprend dans sa partie ROM le système d'exploitation du récepteur 1, le programme de gestion du récepteur de signaux infrarouges 7, et un module de validation 13 du nombre constitué à partir des signaux reçus de la télécommande.

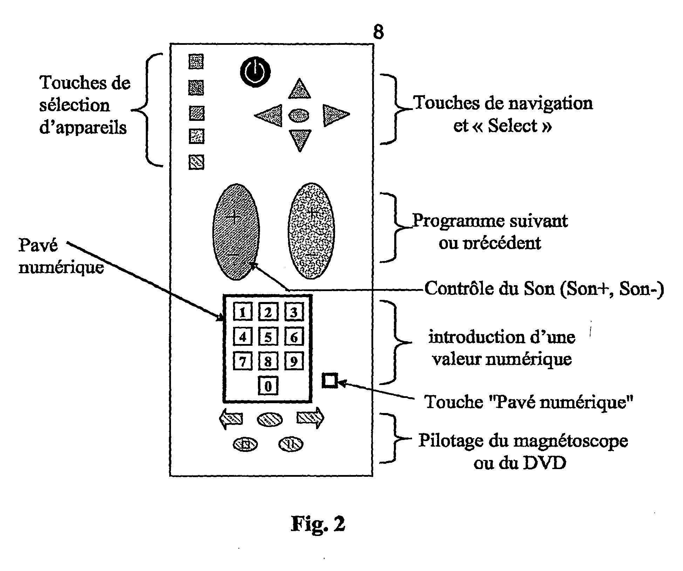

Selon un exemple de réalisation illustré par la figure 2, la télécommande 8 est dotée :
- de touches de sélection d'appareils nécessitant une valeur numérique pour fonctionner, par exemple : un récepteur de télévision, un magnétoscope, un décodeur, ...
- des touches de réglages du son et de sélection de programmes,
- des touches de fonction et notamment une touche référencée "pavé numérique",
- des touches de navigation telles que les touches de direction ↑, ↓, → et ←, touches : « OK » et « Select».
- un pavé numérique comportant dix touches référencées 0 à 9.

Selon une variante de réalisation, la télécommande est dotée d'un écran tactile sur lequel apparaissent des symboles correspondant à des fonctions. L'appui sur le symbole « pavé numérique » fait apparaître un ensemble de dix touches sur l'écran. En appuyant sur les zones de l'écran associées à des chiffres, l'utilisateur introduit un nombre.

La télécommande contient une pile qui alimente un microprocesseur spécialisé et une diode émettrice électroluminescente. Le microprocesseur contient un processeur connu en soi, ainsi que des mémoires ROM et RAM nécessaires, et comprend un modulateur qui délivre des impulsions (destinées à la diode) dont la durée et le nombre sont programmables. De cette façon, la télécommande 8 émet en série des signaux infrarouge Si codés caractéristiques de la touche enfoncée. Ces signaux sont décodés par l'interface 7,9 qui transmet ensuite le code de la touche enfoncée à l'unité centrale 3. Le signal de commande Si (i correspondant au nombre de signaux de commande transmis au récepteur) provenant de la télécommande à destination du récepteur, comporte un message de commande de type connu en soi. Il comporte un champ contenant une valeur numérique allant de 0 à 9, contenant la valeur numérique sélectionnée par l'utilisateur en appuyant sur la touche correspondante. Il peut, en outre, débuter par un champ contenant un bit de départ "un", un champ pour identifier l'appareil préalablement sélectionné par l'utilisateur et que la commande doit contrôler (magnétoscope, téléviseur, décodeur, lecteur et/ou enregistreur de disques,...).

Après avoir montré les différents éléments permettant la réalisation d'un exemple d'un module de commande, nous allons maintenant détailler comment ces éléments coopèrent.

Après avoir allumé son récepteur, l'utilisateur désire sélectionner un canal ou un service identifié par un nombre à trois chiffres. Il lance un Guide Electronique de Programme (EPG en abrégé) qui lui montre la liste des canaux disponibles et peut naviguer dans le guide à l'aide des touches de direction. L'utilisateur peut sélectionner un service en déplaçant l'index sur la liste ou plus directement, introduire le numéro de ce service. Dans le second cas, il appuie alors sur la touche "pavé numérique" ce qui lance le module de validation du nombre. Le module attend la réception de signaux émis par la télécommande lorsque l'utilisateur appuie sur une touche du pavé numérique. Le module de validation traite les données numériques contenues dans les signaux infrarouges, afin de constituer une valeur numérique par la concaténation des différents chiffres. Dans le même temps, l'EPG active une fenêtre d'acquisition du numéro de service à l'écran. Eventuellement, l'EPG affiche aussi la plus grande valeur de numéro de canal disponible, par exemple "699". Si l'utilisateur introduit un « 7 », « 8 » ou « 9 » comme premier chiffre, celui-ci ne peut être considéré comme le chiffre des centaines et donc le numéro de service comprend au plus deux chiffres. De ce fait, une fois le second chiffre introduit, le module de validation considère que les deux chiffres constituent le nombre et le valide.

Après la réception de chaque signal contenant le code d'un chiffre, le module de validation lance une temporisation. Si la temporisation atteint une valeur déterminée, typiquement deux secondes, les chiffres reçus sont validés. Lors de chaque réception, la temporisation est re-initialisée à 0 seconde. La fenêtre d'acquisition affiche la valeur des digits transmis. En variante, ces digits s'affichent sur un écran secondaire en façade du récepteur, typiquement un afficheur électroluminescent. Si le nombre de chiffres transmis dépasse la capacité d'affichage, le premier chiffre disparaît à gauche, le dernier chiffre est mis en positon la plus à droite. A chaque nouveau chiffre introduit, les anciens digits sont décalés vers la gauche.

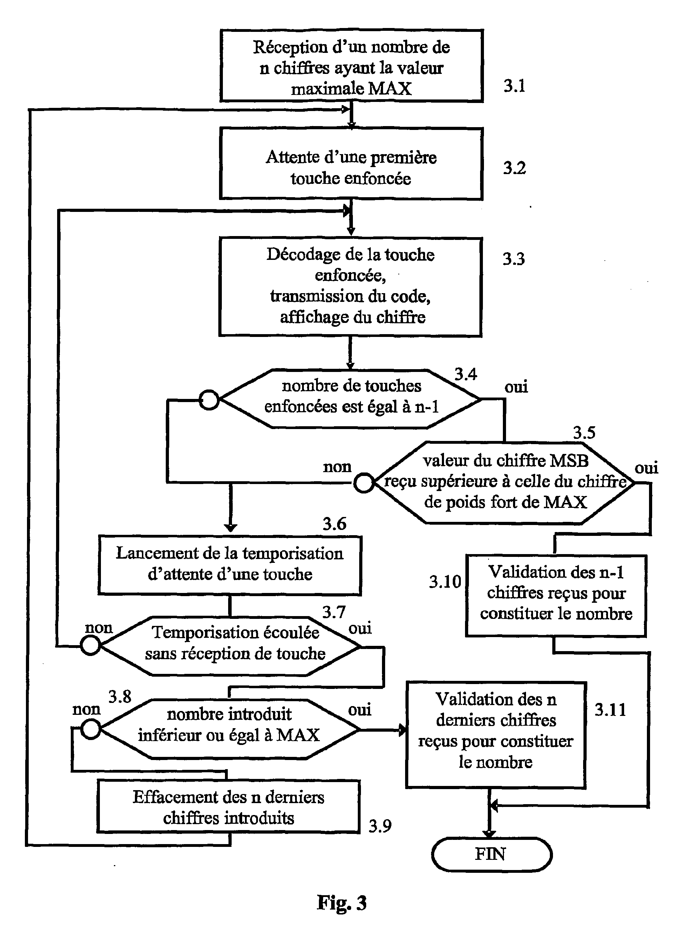

L'organigramme de la figure 3 illustre le déroulement des opérations effectuées par le module de validation du nombre. A l'étape 3.1, le module est lancé avec la valeur maximale MAX comme paramètre d'entrée du nombre à valider. Cela signifie que le module ne validera pas un nombre plus grand que MAX. Le nombre MAX comprend n chiffres. A l'étape 3.2, le module attend que l'utilisateur appuie sur une première touche du pavé numérique. L'utilisateur appuie sur une touche qui est décodée par le microprocesseur spécialisé de la télécommande. Un code correspondant au chiffre introduit est élaboré et transmis dans un signal infrarouge vers l'appareil qui l'affiche sur son écran ou un afficheur quelconque (étape 3.3). Puis à l'étape 3.4, le module compare le nombre de chiffres transmis par la télécommande avec le nombre n de chiffres de la valeur maximale. Si le nombre de chiffres introduits est égal au nombre de chiffres de la valeur maximale (MAX) moins une unité, alors le module saute à l'étape 3.6. Sinon, le module compare à l'étape 3.5, le premier chiffre introduit (qui possède le poids le plus fort - « MSB » selon la terminologie anglaise) et le chiffre le plus significatif de la valeur maximale (MAX). Si le premier chiffre introduit est plus grand que le chiffre le plus significatif de la valeur maximale, alors tous les chiffres ont été reçus. En effet, si un nouveau chiffre est tapé, le nombre résultant des chiffres introduits serait supérieur à la valeur maximale. Le module saute à l'étape 3.10 de validation du nombre. Le nombre validé est la concaténation des n-1 chiffres introduits et l'exécution du module se termine avec comme paramètre de sortie la valeur validée.

Si le nombre de chiffres introduits n'est pas égal au nombre (n-1) de chiffres de la valeur maximale (MAX) moins une unité (test de l'étape 3.4), ou si le chiffre de poids le plus significatif introduit est moins grand ou égal au chiffre le plus significatif de la valeur maximale (test de l'étape 3.5), alors le module saute à l'étape 3.6. A l'étape 3.6, le module lance une temporisation et à l'étape 3.7, il attend la réception d'une touche au cours de ladite temporisation. La temporisation est par exemple de 2 secondes. Si au cours de ces deux secondes, un chiffre est introduit, le module re-boucle à l'étape 3.3 de décodage de la touche, transmission à l'appareil et affichage. Si par contre, la temporisation se termine sans qu'un chiffre ait été introduit, alors le module saute à l'étape 3.8 afin de contrôler si le nombre introduit est bien inférieur à la valeur maximale. Prenons un exemple : la valeur maximale est "650", l'utilisateur peut introduire "670" et attendre la fin de la temporisation, le module ne doit pas valider un tel nombre car il est supérieur à la valeur maximale. Dans ce cas, le module saute à l'étape 3.9 d'effacement des chiffres introduits, et re-boucle à l'étape 3.2 d'attente du premier chiffre introduit. Si à l'étape 3.8, il est vérifié que le nombre introduit est inférieur à la valeur maximale, alors le module considère que l'utilisateur a terminé d'introduire ses chiffres et de ce fait le nombre est validé. Le module saute alors à l'étape 3.11 de validation, le nombre ainsi introduit est la concaténation des n derniers chiffres introduits.

L'utilisateur peut introduire un nombre de chiffres supérieur à n en bouclant par les étapes 3.3, 3.4, 3.6 et 3.7. Mais l'affichage et la validation ne prennent en compte que les n derniers chiffres reçus, les premiers chiffres introduits étant perdus.

Selon un perfectionnement, le récepteur émet un signal sonore ou visuel lorsque le nombre est validé (étape 3.10 ou 3.11).

Une variante consiste en ce que la télécommande soit dotée d'un petit afficheur pour montrer à l'utilisateur le numéro en cours d'introduction. Dans ce cas, le module de validation du nombre se trouve dans la télécommande. La liaison infrarouge entre la télécommande et le récepteur audiovisuel est bidirectionnelle. En fonction de la dernière commande de l'utilisateur vers l'appareil 1, introduction d'un numéro de chaîne par exemple, ce dernier émet vers la télécommande un signal infrarouge contenant la valeur maximale à introduire. Cette valeur est prise en compte par le module de validation de la télécommande de la même façon que celle décrite dans l'organigramme de la figure 3. Lorsque le module de validation valide le nombre introduit (étape 3.10 ou 3.11), la télécommande émet un signal infrarouge contenant le nombre validé. Le signal contient aussi un identificateur de l'appareil nécessitant une valeur numérique pour fonctionner. Cet appareil est généralement celui qui a envoyé la valeur maximale à la télécommande, il peut être aussi celui sélectionné par l'utilisateur à l'aide des touches de sélection d'appareils. Avantageusement, l'afficheur de la télécommande émet un signal graphique indiquant que le nombre est validé et envoyé à l'appareil, par exemple le nombre affiché clignote trois fois.

Selon un perfectionnement, lorsque le nombre à introduire contient n-2 (ou moins) de chiffres que celui de la valeur maximale, l'utilisateur peut écourter la temporisation en appuyant sur la touche « select ». Par exemple, la valeur maximale est « 650 » et l'utilisateur veut introduire « 6 », il appuie alors sur la touche « 6 » puis sur la touche « Select », et le module de validation va considérer que la valeur « 6 » est acquise.

Selon un perfectionnement, si la valeur du premier chiffre introduit est égale à la valeur du premier chiffre de la valeur maximale (MAX), alors le module va comparer les valeurs des chiffres suivants. Lorsque le nombre de chiffres introduit est égale à (n-1), c'est-à-dire le nombre de chiffres de la valeur maximale (MAX) moins une unité, et si la valeur du second chiffre introduit est supérieure à la valeur du second chiffre de la valeur maximale, alors le nombre introduit est validé. Le test sur l'égalité des nombres se poursuit si un certain nombre de chiffres de poids fort sont égaux. Par exemple, supposons que le nombre maximum est 5000. Si l'utilisateur introduit un « 5 », le nombre à introduire peut avoir quatre chiffres. Si l'utilisateur introduit ensuite un « 0 » le nombre à introduire peut toujours avoir quatre chiffres. Mais, si l'utilisateur introduit ensuite le chiffre « 1 », alors le nombre est automatiquement validé puisque l'introduction d'un quatrième chiffre ferait que le nombre introduit dépasse le nombre maximum (MAX).

Bien sûr, l'invention n'est pas limitée au mode de réalisation décrit dans la présente demande. On a vu que le numéro introduit correspond à un numéro de service, mais il peut aussi correspondre à une valeur de fréquence, ou encore à un identifiant de contenu audiovisuel enregistré dans la mémoire 9. De même, l'invention n'est pas limitée à l'introduction d'un numéro à trois chiffres, mais à un ou plusieurs chiffres. Enfin, l'appareil peut être tout appareil électronique nécessitant l'introduction d'une valeur numérique pour son fonctionnement.

## Revendications

1. Procédé de validation d'un nombre comportant une pluralité de chiffres, le nombre ayant une valeur maximale (MAX) ; comportant une pluralité d'étapes d'introduction d'un chiffre (3.2); **caractérisé en ce qu'**il comporte une première étape de validation (3.11) de l'ensemble des chiffres introduits lorsque:
- le nombre de chiffres introduits est égal à celui de la valeur maximale (MAX) moins une unité, et
- le chiffre de poids le plus significatif (MSB) introduit est plus grand que le chiffre de poids le plus significatif de la valeur maximale (MAX).

2. Procédé de validation d'un nombre selon la revendication 1, **caractérisé en ce qu'**il comporte en outre une seconde étape de validation du nombre introduit lorsque le nombre introduit est inférieur ou égal à la valeur maximale (MAX) à la suite d'un signal de fin d'acquisition.

3. Procédé de validation d'un nombre selon la revendication 1 ou 2, **caractérisé en ce qu'**il comporte en outre une étape d'introduction d'une commande (SELECT) par l'utilisateur indiquant la fin d'acquisition de l'ensemble des chiffres introduits.

4. Procédé de validation d'un nombre selon l'une quelconque des revendications précédentes, **caractérisé en ce que** lorsque le nombre de chiffres introduit est égal à celui de la valeur maximale (MAX) moins une unité, et lorsque le chiffre de poids le plus significatif (MSB) introduit est égal au chiffre de poids le plus significatif de la valeur maximale (MAX), alors le procédé comporte un troisième étape de validation de l'ensemble des chiffres introduits si le second chiffre introduit est plus grand que le second chiffre de poids le plus significatif de la valeur maximale (MAX), une comparaison des second chiffres se poursuivant à un chiffre de rang inférieur tant que les chiffres de rang supérieurs sont égaux.

5. Procédé de validation d'un nombre selon l'une quelconque des revendications précédentes, **caractérisé en ce qu'**il comporte une étape d'émission d'un signal sonore ou visuel lors de la validation du nombre.

6. Appareil électronique (1) comprenant des moyens de réception (7) d'une pluralité de signaux associés respectivement à un chiffre pour la constitution d'un nombre, et des moyens de mémorisation (12) d'une valeur maximale ; **caractérisé en ce qu'**il comporte un premier moyen de validation (3,13) de l'ensemble des chiffres introduits activé lorsque les deux événements suivants interviennent : le nombre de chiffres introduits est égal à celui de la valeur maximale (MAX) moins une unité, et le chiffre de poids le plus significatif (MSB) introduit est plus grand que le chiffre de poids le plus significatif de la valeur maximale (MAX).

7. Appareil électronique selon la revendication 6 ; **caractérisé en ce qu'**il comporte un second moyen de validation (3,13) du nombre introduit activé lorsque le nombre introduit est inférieur ou égal à la valeur maximale (MAX).

8. Appareil électronique selon la revendication 6 ou 7; **caractérisé en ce qu'**il comporte un moyen de réception (7) d'un signal de fin d'acquisition (SELECT) du nombre reçu.

9. Appareil électronique selon l'une quelconque des revendications précédentes; **caractérisé en ce qu'**il comporte un troisième moyen de validation (3,13) du nombre introduit activé lorsque les trois événements suivants interviennent ensemble :
- le nombre de chiffres introduits est égal à celui de la valeur maximale (MAX) moins une unité,
- le chiffre de poids le plus significatif (MSB) introduit est égal au chiffre de poids le plus significatif de la valeur maximale (MAX), et
- le second chiffre introduit est plus grand que le second chiffre de poids le plus significatif de la valeur maximale (MAX), la comparaison des second chiffres se poursuivant à un chiffre de rang inférieur tant que les chiffres de rang supérieurs sont égaux.

10. Appareil électronique selon l'une quelconque des revendications 6 à 9 ; **caractérisé en ce qu'**il est une télécommande comportant en outre un moyen de réception d'un signal représentant la valeur maximale (MAX) et, un moyen d'émission d'un signal contenant le nombre validé.

11. Appareil électronique selon la revendication 10 ; **caractérisé en ce que** les moyens de réception comportent un écran tactile affichant un pavé numérique.

## Claims

1. A method of validating a number comprising a plurality of digits, the number having a maximum value (MAX), comprising a plurality of stages of entering a digit (3.2), **characterized in that** it comprises:
a first stage of validating (3.11) the set of digits entered when:
- the number of digits entered is equal to that of the maximum value (MAX) minus a unit, and
- the most significant digit (MSB) entered is greater than the most significant digit of the maximum value (MAX).

2. The method of validating a number as claimed in claim 1, **characterized in that** it further comprises:
a second stage of validating the number entered when the number entered is less than or equal to the maximum value (MAX) following an end of acquisition signal.

3. The method of validating a number as claimed in claim 1 or 2, **characterized in that** it further comprises a stage of entering a command (SELECT) by the user indicating the end of acquisition of the set of digits entered.

4. The method of validating a number as claimed in any of the preceding claims, **characterized in that** when the number of digits entered is equal to that of the maximum value (MAX) minus a unit, and when the most significant digit (MSB) entered is equal to the most significant digit of the maximum value (MAX), then the method includes a third stage of validating the set of digits entered if the second digit entered is greater than the second most significant digit of the maximum value (MAX), a comparison of second digits continuing to a lower ranking digit as long as the higher ranking digits are equal.

5. The method of validating a number as claimed in any of the preceding claims, **characterized in that** it comprises a stage of sending an audio or visual signal when validating the number.

6. An electronic device (1) comprising means of receiving (7) a plurality of signals respectively associated with a digit for forming a number and means of storing (12) a maximum value in memory, **characterized in that** it comprises a first means of validating the set of digits entered when the two following events arise : the number of digits entered is equal to that of the maximum value (MAX) minus a unit, and the most significant digit (MSB) entered is greater than the most significant digit of the maximum value (MAX).

7. The electronic device as claimed in claim 6; **characterized in that** it comprises a second means of validating the number entered when the number entered is less than or equal to the maximum value (MAX).

8. The electronic device as claimed in claim 6 or 7; **characterized in that** it comprises a means of receiving (7) an end of acquisition signal (SELECT) of the number received.

9. The electronic device as claimed in any of the preceding claims, **characterized in that** it comprises a third means of validating the number entered when the three following events arise together :
- the number of digits entered is equal to that of the maximum value (MAX) minus a unit,
- the most significant digit (MSB) entered is equal to the most significant digit of the maximum value (MAX), and
- the second digit entered is greater than the second most significant digit of the maximum value (MAX), the comparison of the second digits continuing to a lower ranking digit as long as the higher ranking digits are equal.

10. The electronic device as claimed in any of claims 6 to 9, **characterized in that** it is a remote control further comprising a means of receiving a signal representing the maximum value (MAX) and a means of sending a signal containing the validated number.

11. The electronic device as claimed in claim 10, **characterized in that** the means of reception comprise a touch screen displaying a numeric keypad.

## Patentansprüche

1. Vorgang der Validierung einer Zahl, die sich aus mehreren Ziffern zusammensetzt, wobei diese Zahl einen Maximalwert (MAX) aufweist; wobei diese Zahl mehrere Etappen des Zifferneingangs (3.2) aufweist; dieser Vorgang wird **dadurch gekennzeichnet, dass**:
er eine erste Etappe der Validierung (3.11) aller eingehenden Ziffern enthält wenn:
- die Zahl der eingehenden Ziffern der dem Maximalwert (MAX) abzüglich einer Einheit entspricht, und wenn
- die eingehende Ziffer mit dem höchsten Stellenwert (MSB) über der Ziffer mit dem höchsten Stellenwert des Maximalwerts (MAX) liegt.

2. Vorgang der Validierung einer Zahl gemäß Patentanspruch 1, der unter anderem **dadurch gekennzeichnet** wird, dass:
er eine zweite Etappe der Validierung der eingehenden Zahl enthält, wenn die eingehende Zahl unter dem Maximalwert (MAX) liegt bzw. diesem entspricht, nachdem ein Signal das Ende einer Erfassung angezeigt hat.

3. Vorgang der Validierung einer Zahl gemäß Patentanspruch 1 oder 2, der unter anderem **dadurch gekennzeichnet** wird, dass er eine Stufe der Befehlseingabe (SELECT) durch den Benutzer enthält, die das Ende der Erfassung aller eingehenden Ziffern angibt.

4. Vorgang der Validierung einer Zahl gemäß einem der vorgenannten Patentansprüche, der **dadurch gekennzeichnet** wird, dass wenn die Zahl der eingehenden Ziffern der dem Maximalwert (MAX) abzüglich einer Einheit entspricht, und wenn die eingehende Ziffer mit dem höchsten Stellenwert (MSB) der Ziffer mit dem höchsten Stellenwerts des Maximalwerts (MAX) entspricht, enthält der Vorgang eine dritte Etappe der Validierung aller eingehenden Ziffern, wenn die zweite eingehende Ziffer über der zweiten Ziffer mit dem höchsten Stellenwert des Maximalwerts (MAX) liegt, wird ein Vergleich der zweiten Ziffern mit einer Ziffern eines niedrigeren Rangs durchgeführt, solange die Ziffern des höheren Rangs gleich sind.

5. Vorgang der Validierung einer Zahl gemäß einem der vorgenannten Patentansprüche, der **dadurch gekennzeichnet** wird, dass er zum Zeitpunkt der Validierung einer Zahl eine Etappe der Aussendung eines Ton- bzw. Sichtsignals enthält.

6. Elektronisches Gerät (1), das Mittel zum Empfang (7) für eine Vielfalt von Signalen, die jeweils einer Ziffer für die Bildung einer Zahl zugeordnet sind, sowie Mittel für die Speicherung (12) eines Maximalwerts enthält; dieses wird **dadurch gekennzeichnet, dass** es ein erstes Mittel zur Validierung aller eingehenden Ziffern enthält, wenn die Zahl der eingehenden Ziffern der des Maximalwerts (MAX) abzüglich einer Einheit entspricht, und wenn die eingehende Ziffer des höchsten Stellenwerts (MSB) der des Maximalwerts (MAX) abzüglich einer Einheit entspricht, und wenn die eingehende Ziffer des höchsten Stellenwerts (MSB) über der Ziffer des höchsten Stellenwerts des Maximalwerts (MAX) liegt.

7. Elektronisches Gerät gemäß Patentanspruch 6, das **dadurch gekennzeichnet** wird, dass es ein zweites Mittel zur Validierung der eingehenden Zahl aufweist, wenn die eingehende Zahl unter dem Maximalwert (MAX) liegt oder diesem entspricht.

8. Elektronisches Gerät gemäß Patentanspruch 6 oder 7, das **dadurch gekennzeichnet** wird, das es ein Mittel zum Empfang (7) eines Signals enthält, das das Ende der Erfassung (SELECT) der erhaltenen Zahl angibt.

9. Elektronisches Gerät gemäß einem der vorgenannten Patentansprüche, das **dadurch gekennzeichnet** wird, dass es ein drittes Mittel zur Validierung der eingehenden Zahl enthält, wenn die Zahl der eingehenden Ziffern dem Maximalwert (MAX) abzüglich einer Einheit entspricht, wenn die eingehende Ziffer mit dem höchsten Stellenwert (MSB) der Ziffer mit dem höchsten Stellenwert des Maximalwerts (MAX) entspricht, und wenn die zweite eingehende Ziffer über der zweiten Ziffer mit dem höchsten Stellenwert des Maximalwerts (MAX) liegt, wird der Test mit einer Ziffer eines niedrigeren Rangs weitergeführt, solange die Ziffern des höheren Rangs gleich sind.

10. Elektronisches Gerät gemäß einem der Patentansprüche 6 bis 9, das **dadurch gekennzeichnet** wird, dass es eine Fernbedienung ist, welche unter anderem mit einem Mittel zum Empfang eines Signals ausgestattet ist, das den Maximalwert (MAX) darstellt, sowie mit einem Mittel zur Aussendung eines Signals mit der validierten Zahl.

11. Elektronisches Gerät gemäß Patentanspruch 10, das **dadurch gekennzeichnet** wird, dass die Empfangsmittel mit einem Touchscreen mit einer Zahlentastatur ausgestattet sind.
